# EUROPÄISCHE PATENTSCHRIFT

(11) **EP 2 097 921 B1**
(45) Veröffentlichungstag und Bekanntmachung des Hinweises auf die Patenterteilung: **24.10.2012**
(21) Anmeldenummer: 08748861.5
(22) Anmeldetag: 03.04.2008
(51) Int. Cl.: H01J 37/32, H02M 7/5387

(54) **HOCHFREQUENZSTROMVERSORGUNGSANORDNUNG, INSBESONDERE EINE PLASMAVERSORGUNGSEINRICHTUNG UND VERFAHREN ZUM BETREIBEN EINER HOCHFREQUENZSTROMVERSORGUNGSEINRICHTUNG**
RADIO-FREQUENCY POWER SUPPLY ARRANGEMENT, IN PARTICULAR A PLASMA SUPPLY DEVICE AND METHOD FOR OPERATION OF A RADIO-FREQUENCY POWER SUPPLY DEVICE
DISPOSITIF D'ALIMENTATION EN COURANT HAUTE FRÉQUENCE, NOTAMMENT DISPOSITIF D'ALIMENTATION EN PLASMA ET PROCÉDÉ D'UTILISATION D'UN DISPOSITIF D'ALIMENTATION EN COURANT HAUTE FRÉQUENCE

(30) Priorität: 23.07.2007 US 951392 P
(43) Veröffentlichungstag der Anmeldung: 09.09.2009
(73) Patentinhaber: Hüttinger Elektronik GmbH & Co. KG, 79111 Freiburg (DE)
(72) Erfinder: GLÜCK, Michael, 79111 Freiburg (DE); MILLER, Alex, 79111 Freiburg (DE); PIVIT, Erich, 71573 Allmersbach im Tal (DE)
(74) Vertreter: Kohler Schmid Möbus
(86) Internationale Anmeldenummer: PCT/EP2008/002657
(87) Internationale Veröffentlichungsnummer: WO 2009/012825

(56) Entgegenhaltungen:
- US-A- 5 363 020
- US-B1- 6 365 868

## Beschreibung

Die Erfindung betrifft eine Hochfrequenzstromversorgungsanordnung, insbesondere eine Plasmaversorgungseinrichtung, zur Erzeugung einer Ausgangsleistung >500 W bei einer Ausgangsfrequenz > 3 MHz mit mindestens einem an eine DC-Stromversorgung angeschlossenen Inverter, der zumindest ein schaltendes Element aufweist, dessen Bezugspotential sich im Takt der Hochfrequenz, insbesondere im Bereich einer Grundfrequenz, ändert, und mindestens einem Ausgangsnetzwerk.

Eine derartige HF-Stromversorgungsanordnung siehe z.B. US 6,365,868, auch Plasmaversorgungseinrichtung genannt, wird zur Plasmastromversorgung, d. h. zur Stromversorgung von Plasmaprozessen eingesetzt. Die Plasmaversorgungseinrichtung arbeitet bei einer Grundfrequenz, die bei dessen Einsatz als Plasmastromversorgung nur geringfügig von einem Sollwert abweichen darf. Typische Grundfrequenzen sind 3,39 MHz, 13,56 MHz, 27 MHz, 40 MHz, 62 MHz. Der Inverter, der das zumindest eine schaltende Element aufweist, generiert aus dem DC-Signal der DC-Stromversorgung ein Wechselsignal, welches periodisch mit der Grundfrequenz sein Vorzeichen ändert. Dazu wird das zumindest eine schaltende Element im Takt der Grundfrequenz zwischen einem leitenden und einem nichtleitenden Zustand hin- und hergeschaltet. Das Ausgangsnetzwerk generiert aus dem durch den Inverter generierten Wechselsignal ein sinusförmiges Ausgangssignal im Wesentlichen bei der vorgegebenen Grundfrequenz.

Bei einem Plasma handelt es sich um einen besonderen Aggregatzustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch Zufuhr von Energie die Atome bzw. Moleküle in positive und negative Ladungsträger, also in Ionen und Elektronen, aufgespaltet werden. Ein Plasma eignet sich zur Bearbeitung von Werkstücken, da die elektrisch geladenen Teilchen chemisch hochgradig reaktiv und zudem durch elektrische Felder beeinflussbar sind. Die geladenen Teilchen können mittels eines elektrischen Feldes auf ein Werkstück beschleunigt werden, wo sie beim Aufprall einzelne Atome aus dem Werkstück herauslösen können. Die herausgelösten Atome können über Gasfluss abtransportiert werden (Ätzen) oder auf anderen Werkstücken als Beschichtung abgelagert werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz, Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität.

Weiterhin kann ein Plasma auch zur Anregung von Lasern, insbesondere Gaslasern dienen.

Um aus einem Gas ein Plasma zu generieren, muss ihm Energie zugeführt werden. Das kann auf unterschiedliche Weise, beispielsweise über Licht, Wärme oder elektrische Energie erfolgen. Ein Plasma zur Bearbeitung von Werkstücken wird typischerweise in einer Plasmakammer gezündet und aufrechterhalten. Dazu wird in der Regel ein Edelgas, z. B. Argon, mit niedrigem Druck in die Plasmakammer geleitet. Über Elektroden und/oder Antennen wird das Gas einem elektrischen Feld ausgesetzt. Ein Plasma entsteht - bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirkt die natürliche Rekombination entgegen, d. h. Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Plasmastromversorgungen müssen möglichst kleine Abmessungen besitzen, damit sie in der Anwendung nah an den Plasmaentladungen angeordnet werden können. Sie sollen möglichst wiederholgenau und exakt arbeiten und möglichst geringe Verluste aufweisen, um einen hohen Wirkungsgrad zu realisieren. Eine weitere Anforderung sind möglichst geringe Herstellungskosten und hohe Wartungsfreundlichkeit. Nach Möglichkeit sollen Plasmastromversorgungen ohne mechanisch angetriebene Bauteile auskommen, insbesondere sind Lüfter aufgrund ihrer begrenzten Lebensdauer und der Gefahr von Verschmutzungen unerwünscht. Weiter sollen Plasmastromversorgungen gleichzeitig möglichst zuverlässig sein, sich nicht überhitzen und eine lange Betriebsdauer aufweisen.

Das Ausgangsnetzwerk hat zumindest einen inverterseitigen Anschluss und einen lastseitigen Anschluss. Anschlüsse auf der Inverterseite werden auch Primäranschlüsse, solche auf der Lastseite Sekundäranschlüsse genannt. Ein Leistungszug von einem der Anschlüsse zu einem zweiten Anschluss derselben Seite wird als Ausgangsnetzwerkleitung bezeichnet. Dieser zweite Anschluss kann auch auf einer HF-mäßigen Masse liegen. Beispielsweise kann der Ausgang des Inverters, der das Wechselsignal führt, an einen ersten inverterseitigen Anschluss des Ausgangsnetzwerks angeschlossen sein. Von dort kann ein Leitungszug innerhalb des Ausgangsnetzwerks direkt oder über weitere Bauelemente zu einem Ende einer Primärwicklung eines Ausgangsübertragers führen. Vom anderen Ende der Primärwicklung kann ein weiterer Leitungszug direkt oder über weitere Bauelemente zu einem zweiten inverterseitigen Anschluss des Ausgangsnetzwerks führen. Diese Leitung vom ersten inverterseitigen Anschluss über die Primärwicklung zum zweiten inverterseitigen Anschluss des Ausgangsnetzwerks stellt eine Ausgangsnetzwerkleitung im Sinne der Erfindung dar.

Die Ausgestaltung des Inverters als dem Fachmann bekannte Halbbrückenschaltung erfordert zwei schaltende Elemente, zum Beispiel zwei MOSFET-Transistoren, von denen der eine mit dem positiven und der andere mit dem negativen Pol der DC-Stromversorgung verbunden ist. Die beiden Transistoren werden mit der Grundfrequenz komplementär angesteuert, das Wechselsignal weist damit abwechselnd das positive und das negative Potential der DC-Stromversorgung auf.

Der zweite Primäranschluss kann über einen Kondensator an mindestens einen Pol der DC-Stromversorgung angeschlossen werden und stellt damit die hochfrequenzmäßige Masse dar. Alternativ dazu kann der Inverter eine weitere Halbbrücke haben, die an diesem zweiten Primäranschluss angeschlossen sind und die im Gegentakt zu der Halbbrücke am ersten Primäranschluss betriebenen wird. Bei der Verwendung von jeweils einer Halbbrücke an jedem der beiden Primäranschlüsse spricht man von einer Vollbrückenschaltung.

Die Ansteuerung der MOSFET-Transistoren erfolgt über die Gate-Source-Spannung, wobei der Source-Anschluss als der spannungsmäßige Bezugspunkt dieses Bauteils angesehen werden kann.

Weil N-Kanal-MOSFETs Vorteile gegenüber P-Kanal-MOSFETs haben, nimmt man vorzugsweise N-Kanal-MOSFETs für beide schaltende Elemente einer Halbbrücke.

Die Source-Anschlüsse der mit dem negativen Anschluss der DC-Stromversorgung verbundenen N-Kanal-MOSFETs (Bottom Switch) liegen auf einem ruhigen negativen Potential, da bei diesen die Drain-Anschlüsse das Wechselsignal mit der Grundfrequenz der Plasmastromversorgungseinrichtung aufweisen und an den jeweiligen Primäranschluss des Ausgangsnetzwerks angeschlossen sind, während die Source-Anschlüsse direkt mit dem negativen Pol der DC-Stromversorgung verbunden sind.

Die mit dem positiven Anschluss der DC-Stromversorgung verbundenen N-Kanal-MOSFETs (Top Switch) müssen jedoch so geschaltet werden, dass deren jeweiliger Drain-Anschluss an den Pluspol der DC-Stromversorgung angeschlossen ist. Damit sind die Source-Anschlüsse an die Ausgangsnetzwerkleitung des Ausgangsnetzwerkes angeschlossen und führen das Wechselsignal. Da auch bei diesen Transistoren die Ansteuerung relativ zum Source-Anschluss mit seinem schnell wechselnden hohen Potentialunterschied erfolgen muss, müssen auch die Gate-Ansteuerungen dieser Transistoren und eventuell für die Gate-Ansteuerungen notwendige Bauteile als Treiber und deren Treiberstromversorgung relativ zu diesem hochfrequenten Bezugspotential erfolgen. Eine durch den schnellen Potentialwechsel bedingte falsche Gate-Source-Spannung kann leicht zu Instabilitäten der Halbbrücke und zur Zerstörung von Bauelementen führen. Auch elektrische Messwerte zur Überwachung, beispielsweise von internen Temperatursensoren der MOSFETs oder ihrer Treiberstufen, können den Source-Anschluss als Bezugspotential haben und weisen damit ebenfalls ein starkes HF-Potential auf.

Aufgabe der vorliegenden Erfindung ist es, eine Hochfrequenzstromversorgungsanordnung bereitzustellen, die den genannten Anforderungen für eine Plasmastromversorgung genügt und eine sichere Versorgung, Ansteuerung oder Überwachung auch derjenigen schaltenden Elemente oder weiterer Bauteile gewährleistet, deren Bezugspunkt schnellen Potentialwechseln ausgesetzt ist.

Erfindungsgemäß wird die Aufgabe durch eine HF-Stromversorgungsanordnung der eingangs genannten Art gelöst, wobei eine Begleitleitung ein elektrisches Bauteil, das sich auf einem Bezugspotential mit starken zeitlichen Änderungen befindet, mit einem von zeitlichen Veränderungen eines Spannungspotentials, insbesondere bei der Grundfrequenz, freien oder zumindest weitgehend freien Zugangspunkt verbindet. Das Bauteil kann Bestandteil des Inverters oder mit diesem verbunden sein, z.B. ein Treiber oder eine Messeinrichtung.

Die Begleitleitung verbindet ein elektrisches Bauteil, beispielsweise des Inverters, dessen Bezugspunkt auf einem Potential der Ausgangsnetzwerkleitung des Ausgangsnetzwerkes mit starken zeitlichen Veränderungen liegt, mit einem von zeitlichen Veränderungen eines Potentials weitgehend freien Zugangspunkt, der sich im Bereich, also in räumlicher Nähe eines hochfrequenzmäßig ruhigen Punktes der Ausgangsnetzwerkleitung des Ausgangsnetzwerkes befinden kann. An der Stelle, an der die Ausgangsnetzwerkleitung des Ausgangsnetzwerks an das Bauteil angeschlossen ist und dessen Bezugspunkt dadurch ein gegenüber der DC-Stromversorgung oder der Gerätemasse stark wechselndes Potential aufweist, weist auch die Begleitleitung dieses stark wechselnde Potential auf. An der Stelle, an der die Ausgangsnetzwerkleitung des Ausgangsnetzwerks hochfrequenzmäßig ruhig ist, weist auch die Begleitleitung wenig oder kein HF-Potential auf. Die Stärke des Hochfrequenzpotentials wird über die Wegstrecke der Begleitleitung durch induktive und kapazitive Kopplung an die Ausgangsnetzwerkleitung abgebaut.

Der Vorteil der Erfindung besteht darin, dass man das Bauteil, dessen Bezugspunkt ein zeitlich ständig veränderliches Bezugspotential hat, von einem hochfrequenzmäßig relativ ruhigen Zugangspunkt über die Begleitleitung elektrisch versorgen, steuern oder überwachen kann.

Die Begleitleitung kann zu der Ausgangsnetzwerkleitung des Ausgangsnetzwerks in räumlicher Nähe angeordnet sein, was bedeutet, dass beide Leitungen voneinander beabstandet sind und im Kopplungsbereich allein schon durch die Kapazität zwischen den beiden Leitungen kapazitiv und durch die Induktivitäten der Leitungen induktiv miteinander gekoppelt sind. Die Begleitleitung befindet sich also im Bereich der Ausgangsnetzwerkleitung. Sie verläuft zumindest abschnittsweise entlang der Ausgangsnetzwerkleitung.

So kann die Begleitleitung parallel zur Ausgangsnetzwerkleitung geführt sein, mit ihr verdrillt oder bifilar angeordnet sein. Dabei sollen sich die magnetischen Feldlinien eines Magnetfeldes, die sich um die Ausgangsnetzwerkleitung auf Grund des durch sie fließenden Stromes bilden, möglichst vollständig auch die Begleitleitung umschließen, wodurch eine hohe magnetische Kopplung erreicht wird.

Die Begleitleitung kann räumlich oder flächig von der Ausgangsnetzwerkleitung umgeben oder umschlossen sein. Beispielsweise kann die Ausgangsnetzwerkleitung planar ausgeführt sein, wobei die Begleitleitung in der Mitte der Ausgangsnetzwerkleitung ausgeführt ist. Alternativ kann die Begleitleitung von einer rohrförmigen Ausgangsnetzwerkleitung umschlossen sein.

Die Begleitleitung kann eine wesentlich kleinere Dimension haben als die Ausgangsnetzwerkleitung.

Das meiste Hochfrequenzpotential der Ausgangsnetzwerkleitung fällt an der Primärwicklung des Ausgangsübertragers ab, die der Hauptfunktionsteil der Ausgangsnetzwerkleitung ist. Hier kann die Begleitleitung als Begleitwicklung ausgeführt sein. Da Begleitwicklung und Primärwicklung genau dieselbe geometrische Form annehmen, unterliegen sie denselben hochfrequenten magnetischen Einflüssen.

Die Begleitleitung kann einen Zugangspunkt in der Nähe einer Stelle der Ausgangsnetzwerkleitung haben, die von zeitlichen Veränderungen des Hochfrequenzpotentials weitgehend frei ist. Weist der Inverter zwei Halbbrücken auf, die die Primärwicklung des Ausgangsübertragers gegenläufig treiben, kann der Zugangspunkt der Begleitleitung in der Nähe der Mitte der Primärwicklung liegen. Um die Mitte der Primärwicklung definiert abzublocken und damit hochfrequenzmäßig ruhig zu halten, kann sie mit einer Anzapfung versehen sein und mit einem Mittelpunkt der DC-Stromversorgung des Inverters verbunden sein, welcher durch zwei Kondensatoren gebildet ist, die in Serie zu den Anschlüssen der DC-Stromversorgung liegen.

Zu den schaltenden Elementen einer jeden Halbbrücke, deren Bezugspunkte ein stark wechselndes Potential aufweisen, kann von Zugangspunkten in der Nähe der Mittelanzapfung der Primärwicklung aus jeweils eine eigene Begleitwicklung gehen, die sich am Verlauf der Primärwicklung orientiert.

Ist die Ausgangsnetzwerkleitung als ganzes oder teilweise als planare Struktur auf einer Leiterplatte ausgeführt, kann die - Begleitleitung von der Ausgangsnetzwerkleitung isoliert in der Mitte der Struktur geführt sein. Die Begleitleitung kann dabei von der Ausgangsnetzwerkleitung umschlossen sein. Die Begleitleitung kann auf einer weiteren Lage einer mehrlagigen Leiterplatte parallel zur Ausgangsnetzwerkleitung angeordnet sein.

Die Ausgangsnetzwerkleitung und die Begleitleitungen können über ihre Eigenkapazität hinaus kapazitiv miteinander verbunden sein. Dies kann über mindestens einen diskreten Kondensator erfolgen. Der Kondensator kann induktionsarm geschaltet sein. Eine Erhöhung der kapazitiven Kopplung kann erzielt werden, wenn jeweils ein Kondensator an mehreren Stellen angeordnet ist. Dies kann in der Nähe des hochfrequenzmäßig ruhigen Punktes an der Mittelanzapfung der Primärwicklung, in der Nähe des schaltenden Elementes, z. B. eines MOSFETs, oder über die gesamte Ausdehnung des gemeinsamen Weges an beliebigen Stellen jeweils gleicher Wegstrecke von Ausgangsnetzwerkleitung und Begleitleitung bzw. Primärwicklung und Begleitwicklung erfolgen.

Darüber hinaus kann die Begleitleitung durch mindestens ein, ein Magnetfeld erhöhendes Bauteil des Ausgangsübertragers geführt sein. Dadurch wird eine besonders gute induktive Kopplung erreicht.

Die Begleitleitung kann gemeinsam mit einer Ausgangsnetzwerkleitung durch das Magnetfeld erhöhende Element geführt sein.

Erfordert die elektrische Versorgung, Steuerung oder Beobachtung des Bauteils mehrere Anschlüsse, so können entsprechend mehrere Begleitleitungen in der beschriebenen Weise entlang der Ausgangsnetzwerkleitung geführt werden. Bei bestimmten Schaltungen und bestimmten Signalen, beispielsweise bei der Stromversorgung des Bauteils, bietet es sich auch an, alternativ zu einer zweiten Begleitleitung die Ausgangsnetzwerkleitung für diesen Zweck mit zu benutzen.

Ist das Bauteil zum Beispiel ein Treiber für einen Top-Switch-MOSFET, kann der erste Pol der Treiberstromversorgungsquelle an den Zugangspunkt der Begleitleitung, der zweite Pol an die Mittelanzapfung der Ausgangsnetzwerkleitung angeschlossen werden. So erfolgt die Treiberstromversorgung für den einen Pol über die Begleitleitung, für den zweiten Pol über die Ausgangsnetzwerkleitung. Die Treiberstromversorgungsquelle bleibt dabei auf einem hochfrequenzmäßig ruhigen Potential. Auf eine Common-Mode-Drossel zwischen der Treiberstromversorgungsquelle und dem Treiber selbst kann bei dieser Schaltungsanordnung verzichtet werden.

Sind mehrere solcher Halb- oder Vollbrückenschaltungen in einer Plasmaversorgungseinrichtung vorhanden, können alle Top-Switch-Treiber als Gruppe von einer gemeinsamen Treiberstromversorgungs-quelle gespeist werden, da alle Zugangspunkte der Begleitleitungen auf einem hochfrequenzmäßig ruhigen Potential liegen. Da auch die Common-Mode-Drosseln in allen Treiberstromversorgungsleitungen wegfallen können, kann ebenso die Gruppe Bottom-Switch-Treiber direkt von einer gemeinsamen Treiberstromversorgungsquelle gespeist werden; die aus Symmetriegründen hier vorher ebenfalls erforderlichen Common-Mode-Drosseln können gleichfalls wegfallen. Damit werden Kosten und Platz eingespart werden. Bisher wurde für jeden Treiber eine eigene Treiberstromversorgungsschaltung mit galvanischer Trennung vorgesehen.

Solche Begleitleitungen können auch die Ansteuersignale von den Treibern zu den schaltenden Elementen führen. Bei dieser Variante können die zugehörigen Treiber auf einem hochfrequenzmäßig ruhigen Potential bleiben, während sich die Bezugspunkte der zugehörigen schaltenden Elemente auf einem stark wechselnden Potential befinden. Auch bei dieser Schaltungsvariante genügt eine Treiberstromversorgungsquelle je genannter Gruppe.

In einer anderen Weiterbildung der Erfindung werden Messsignale, die von den Bauteilen auf dem hochfrequent wechselnden Potential, z. B. den Top-Switch-Treibern oder den zugehörigen schaltenden Elementen stammen, zu einer hochfrequenzmäßig ruhigen Stelle geführt. Auf diese Weise können beispielsweise elektrische Signale einer Temperaturmessung oder eines bestimmten Zustandes mit einer Schaltung ausgewertet werden, die auf Massepotential oder zumindest auf einem hochfrequenzmäßig ruhigen Potential liegt.

Der Inverter kann auch als Halbbrücke ausgebildet sein, wobei der von zeitlichen Veränderungen eines elektrischen Potentials weitgehend freie Zugangspunkt der Begleitleitung in der Nähe des hochfrequenzmäßig ruhigen Endes der Ausgangsnetzwerkleitung liegen kann. Ist ein Primäranschluss direkt oder über einen Kondensator an Masse oder an einen Pol der DC-Stromversorgung angeschlossen und damit hochfrequenzmäßig ruhig, so kann der Zugangspunkt der Begleitleitung in dessen Nähe sein.

Die Erfindung lässt zahlreiche Ausführungsformen zu. Einige davon sollen anhand der in der Zeichnung dargestellten Figuren näher erläutert werden.

Es zeigt:
- Figur 1:: Hochfrequenzstromversorgungsanordnung mit Mitteleinspeisung
- Figur 2:: Ansteuerung eines schaltenden Transistors sowie eine Treiberstromversorgung nach dem Stand der Technik
- Figur 3:: Ausführungsbeispiel einer Treiberansteuerung eines schaltenden Transistors mit Mitteleinspeisung
- Figur 4:: Darstellung des Ausgangsnetzwerkes gemäß Figur 3
- Figur 5:: Ausführungsbeispiel einer Treiberansteuerung für einen schaltenden Transistor mit Mitteleinspeisung in einer Vollbrücke
- Figur 6:: Ausführungsbeispiel einer Gateansteuerung für einen schaltenden Transistor mit Mitteleinspeisung in einer Vollbrücke
- Figur 7:: Ausführungsbeispiel einer Treiberansteuerung für schaltende Transistoren in einer Halbbrücke
- Figur 8:: Ausführungsbeispiel einer Gate-Ansteuerung für schaltende Transistoren in einer Halbbrücke
- Figur 9:: Lagen einer mehrlagigen Leiterplatte mit einer Mitteleinspeisung und bifilar geführten Treiberstromversorgungsfeitungen

Gleiche Merkmale sind mit gleichen Bezugszeichen gekennzeichnet.

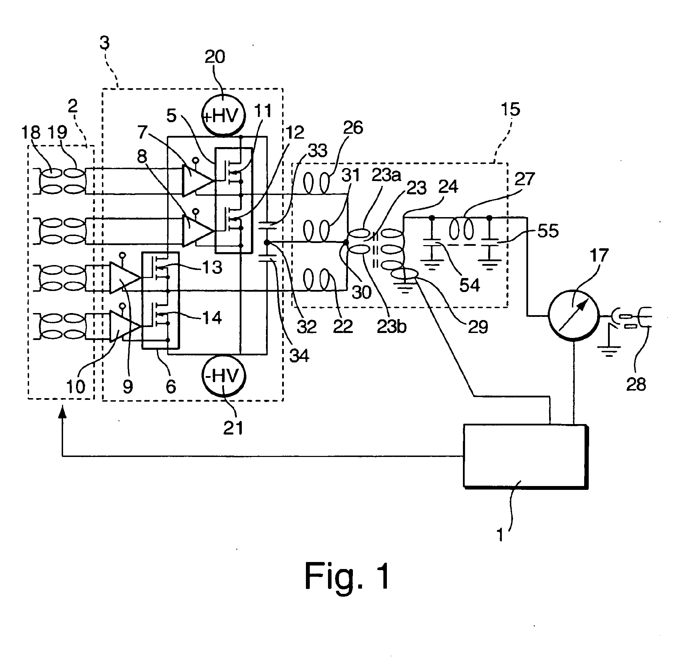

In Figur 1 ist eine Hochfrequenzstromversorgungsanordnung dargestellt, wie sie zur Stromversorgung für Plasmaprozesse Verwendung findet. Dabei werden Ausgangsleistungen von mehr als 500 W bei einer Frequenz > 3 MHz erzeugt. Die Hochfrequenzstromversorgungsanordnung besteht aus einer Steuerung 1, welche an einen Signalübertrager 2 führt. Der Signalübertrager 2 bewirkt eine galvanische Trennung der Steuersignale von der Hochspannung. Dieser Signalübertrager 2 ist mit einem Vollbrückenmodul 3 verbunden, wobei in das Vollbrückenmodul 3 neben zwei Halbbrücken 5 und 6 Treiber 7, 8, 9, 10 für die Halbbrückentransistoren 11, 12 und 13, 14 integriert sind. Das als Inverter arbeitende Vollbrückenmodul 3 ist an ein Ausgangsnetzwerk 15 geführt, das wiederum über eine Messeinrichtung 17 mit einer externen, nicht weiter dargestellten Last über den Ausgangsanschluss 28 verbunden ist.

Die Steuerung 1 steuert die vier Primärwicklungen des Signalübertragers 2 mit einer Grundfrequenz von beispielsweise 3,39 MHz an. Die Sekundärwicklungen sind an die Eingänge der Treiber 7, 8, 9, 10 angeschlossen; insbesondere besteht der erste Zweig des Signalübertragers aus der Primärwicklung 18 und der Sekundärwicklung 19, welche an den Eingang des Treibers 7 angeschlossen ist.

Der Signalübertrager kann auch so realisiert sein, dass er mit optischen Signalen arbeitet.

Jede Halbbrücke 5, 6 enthält zwei als MOSFETs ausgebildete Transistoren 11, 12 bzw. 13, 14, wobei die Transistoren 11 und 13 (Top Switch) mit einer positiven Gleichspannung 20 und die Transistoren 12 und 14 (Bottom Switch) mit einer negativen Gleichspannung 21 verbunden sind. Das Gate jedes Transistors 11, 12 bzw. 13, 14 ist mit jeweils dem Ausgang eines Treibers 7, 8, 9, 10 verbunden.

Der Treiber 9 schaltet den Transistor 13 in Abhängigkeit der von der Steuerung 1 bereitgestellten Grundfrequenz. Dasselbe erfolgt durch den Treiber 10 mit dem Transistor 14. Dabei ist immer höchstens ein Transistor 13, 14 der Halbbrücke 6 leitend, während der andere gesperrt ist. Diese Arbeitsweise gilt phasenverschoben auch für die Treiber 7 und 8 und die Transistoren 11, 12 der Halbbrücke 5.

Somit wird aus der Gleichspannung ein hochfrequentes Wechselsignal erzeugt, welches mit der Grundfrequenz periodisch sein Vorzeichen ändert. Dieses Wechselsignal wird von der Halbbrücke 5 über eine erste Induktivität 26 an die Primärwicklung 23 des Ausgangsübertragers 23, 24 geführt. Das Ausgangssignal der zweiten Halbbrücke 6 führt über eine zweite Induktivität 22 ebenfalls an die Primärwicklung 23 des Ausgangsübertragers 23, 24 des Ausgangsnetzwerkes 15. Die Sekundärwicklung 24 des Ausgangsübertragers 23, 24 gibt das Hochfrequenzsignal über ein Impedanzanpassungsglied mit den Kondensatoren 54 und 55 sowie der Induktivität 27 an einen Ausgangsanschluss 28 weiter, der mit einer externen Last verbunden ist.

Eine Strommessung 29 in der Sekundärwicklung 24 des Ausgangsübertragers 23, 24 sowie die Messeinrichtung 17 sind mit der Steuerung 1 verbunden.

Die Primärwicklung 23 des Ausgangsübertragers 23, 24 weist eine Mittelanzapfung 30 auf, wodurch die Primärwicklung 23 in zwei Primärwicklungshälften 23a und 23b unterteilt ist. Die Mittelanzapfung 30 führt über eine dritte Induktivität 31 an den Mittelpunkt 32 eines kapazitiven Spannungsteilers 33, 34, der zwischen dem positiven Gleichspannungsanschluss 20 und dem negativen Gleichspannungsanschluss 21 angeordnet ist. Die beiden Kondensatoren 33, 34 des Spannungsteilers arbeiten als Bypasskondensatoren für die Halbbrücken 5 und 6. Durch diese Bypasskondensatoren 33, 34 werden Stromspitzen beim Schalten der Transistoren 11, 12, 13, 14 ausgeglichen. Gleichzeitig werden somit Spannungseinbrüche in der DC-Stromversorgung mit ihren Anschlüssen 20, 21 verhindert.

Die erste, zweite und dritte Induktivität 26, 22, 31 sind nur für das Schaltverhalten der Transistoren verantwortlich und können je nach Ausführung der Transistoren auch durch direkte Verbindungen ersetzt sein.

In der beschriebenen Inverter-Anordnung als Halb- oder Vollbrücke gibt es schaltende Elemente mit schwankendem ("floating") Referenzpotential. Das bedeutet, dass das Bezugspotential nicht immer zeitlich konstant gegenüber den beiden Potentialen der DC-Stromversorgung 50 ist. Bei der in Figur 1 beschriebenen Schaltung trifft dies auf die Transistoren 11 und 13 zu, deren Source-Anschlüsse auf einem hochfrequenzmäßig unruhigen Punkt liegen und deren Bezugspotential gegenüber der Masse der HF-Stromversorgung zwischen relativ hohen Potentialen, oftmals einigen hundert Volt, mit der Grundfrequenz hin- und herspringt, sowie auf das Bezugspotential der zugehörigen Treiber 7, 9. Für ein ordnungsgemäßes Funktionieren der Treiber sollen die elektrischen Potentiale der Treiberstromversorgungsleitungen am Treiber 7 bzw. 9 gegenüber dem Bezugspotential des jeweils angeschlossenen Top-Switch-Transistors 11 bzw. 13 keine zeitlichen Veränderungen aufweisen.

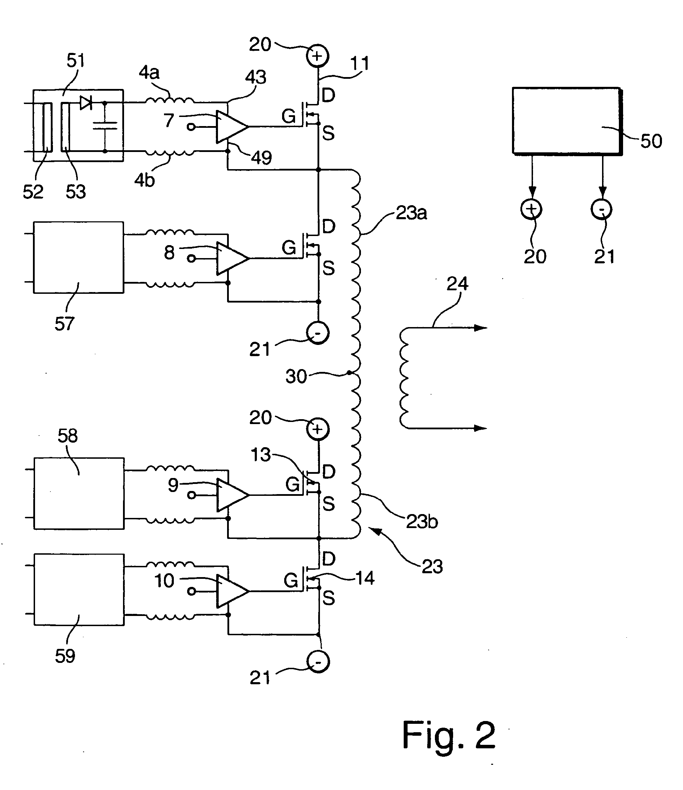

In Figur 2 ist diese an sich bekannte Schaltung nur für die Treiberstromversorgung des Top-Switch-Treibers 7 näher beschrieben. Weiterhin sind nur die Vollbrückentransistoren 11, 12, 13, 14 und die Primärwicklung 23 und Sekundärwicklung 24 des Ausgangsübertragers 23, 24 des Ausgangsnetzwerkes 15 angedeutet. Es sind somit nur die für das Verständnis der Erfindung wesentlichen Elemente dargestellt.

Über einen Gleichrichter und die erste Hälfte 4a der Common-Mode-Drossel ist die Sekundärwicklung 53 des Transformators in der Treiberstromversorgungsquelle 51 mit dem Power-In-Anschluss 43 des Treibers 7 verbunden. Der zweite Anschluss der Sekundärwicklung 53 der Treiberstromversorgungsquelle 51 führt über die zweite Hälfte 4b der Common-Mode-Drossel an den Power-Ground-Anschluss 49.

Die Common-Mode-Drossel mit den beiden Hälften 4a und 4b ist erforderlich, da die parasitären Koppelkapazitäten des Transformators 52, 53, der den Treiber 7 mit Betriebspannung versorgt, nicht beliebig klein sind und Hochfrequenzströme von dem auf Hochfrequenzpotential liegenden Treiber 7 über den Transformator 52, 53 zur Versorgungsschaltung der Primärwicklung 52 vermieden werden sollen.

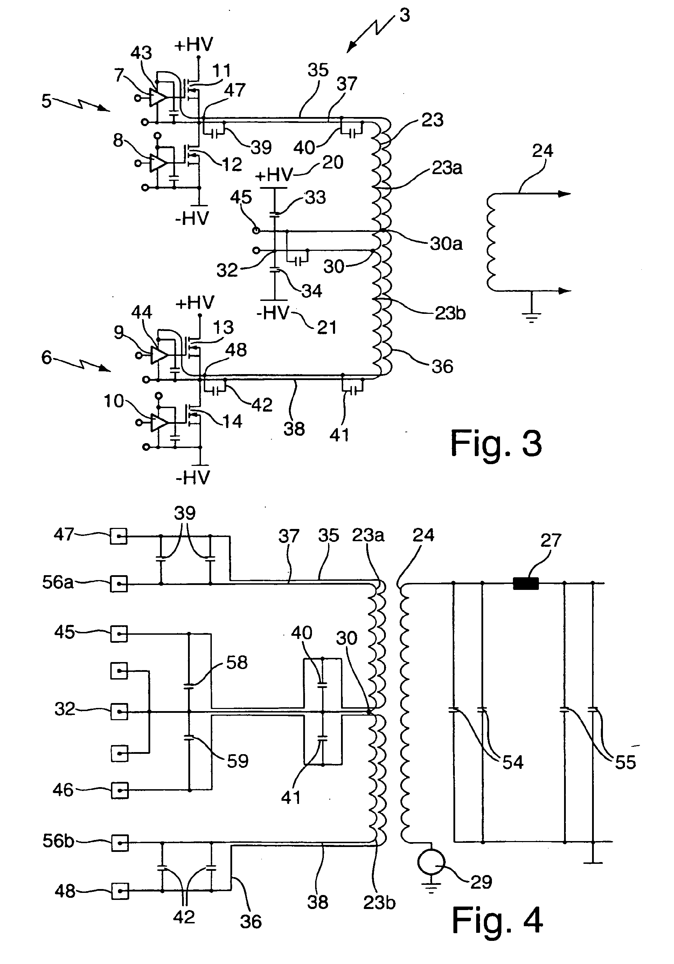

Mit Hilfe von Figur 3 soll das Prinzip der Begleitleitung am Vollbrückenmodul 3 prinzipiell erläutert werden. Für jede Halbbrücke 5, 6 ist eine Begleitleitung 35, 36 zur Versorgung der Treiber 7, 9 vorgesehen. Die Begleitleitung 35 sowie die Ausgangsnetzwerkleitung mit der hochfrequenzmäßig ruhigen Mittelanzapfung 30 der Primärwicklung 23 werden dazu genutzt, um die Betriebsspannung an den Treiber 7 des Top-Switch-Transistors 11 zu führen. Auch dem Treiber 9 des zweiten Top-Switch-Transistors 13 kann auf diese Weise Betriebsspannung zugeführt werden.

Für die Halbbrücke 5 führt diese Begleitleitung 35 von einem Anschluss 45 der Treiberstromversorgungsquelle aus in der Nähe der Mittelanzapfung 30 zum Zugangspunkt 30a, folgt der Geometrie der Windungen der oberen Hälfte 23a der Primärwicklung 23 des Ausgangsübertragers 23, 24 und denen der ersten Induktivität 26 und führt an den Treiber 7. Im Knotenpunkt 47 ist die Begleitleitung 35 an den Power-In-Anschluss 43 des Treibers 7 angeschlossen.

Begleitleitung 35 und die obere Hälfte 23a der Primärwicklung 23 können dabei parallel oder bifilar geführt sein, wodurch beide magnetisch miteinander verkoppelt sind.

Der Treiber 9 der zweiten Halbbrücke 6 nutzt dieselbe Treiberstromversorgungsquelle. Die Begleitleitung 36 ist bis zum Zugangspunkt 30a identisch mit der Begleitleitung 35, folgt aber dann der Geometrie der Windungen der unteren Hälfte 23b der Primärwicklung 23 des Ausgangsübertragers 23, 24 und führt an den Treiber 9. Im Knotenpunkt 48 ist die Begleitleitung 36 an den Power-In-Anschluss 44 des Treibers 9 angeschlossen.

Die zweite Begleitleitung 36 folgt dabei der Ausgangsnetzwerkleitung 38, insbesondere der unteren Hälfte 23b der Primärwicklung 23. Begleitleitung 36 und die untere Hälfte 23b der Primärwicklung 23 können dabei parallel oder bifilar geführt sein, wodurch beide magnetisch miteinander gekoppelt sind.

Jede der Begleitleitungen 35, 36 ist mit der jeweilig mitlaufenden Ausgangsnetzwerkleitung 37, 38 über mehrere Kondensatoren verbunden. So sind die Begleitleitung 35 und die Hochfrequenzleitung 37 über die Kondensatoren 39 und 40 verbunden. Die Begleitleitungsleitung 36 und die Hochfrequenzleitung 38 sind über die Kondensatoren 41 und 42 gekoppelt.

Das zweite Potential der Treiberstromversorgungsquelle ist an den Mittelpunkt 32 angeschlossen und gelangt von dort über die dritte Induktivität 31 auf die Mittelanzapfung 30 der Primärwicklung 23. An den beiden Enden der Primärwicklung 23 ist dieses Potential jedoch um das dort jeweils herrschende Hochfrequenzpotential verschoben, auf dem sich auch die Transistoren 12 bzw. 13 mit ihren Source-Anschlüssen befinden.

In Figur 4 ist noch einmal die genaue Beschaltung des Ausgangsübertragers 23, 24 des Ausgangsnetzwerkes 15 dargestellt. Die schaltenden Elemente sind nicht dargestellt. Die Hochfrequenz-Ausgangsnetzwerkleitung 37, die auch den Primärwicklungshälfte 23a umfasst, sowie die Hochfrequenz-Ausgangsnetzwerkleitung 38, die auch den Primärwicklungshälfte 23b umfasst, erstreckt sich vom Primäranschluss 56a für das Wechselsignal von der ersten Halbbrücke über die Primärwicklung 23 und von dieser an den Primäranschluss 56b für das Wechselsignal von der zweiten Halbbrücke.

In dieser Schaltungsausführung sind die Begleitleitungen 35, 36 schon von den Anschlüssen 45, 46 aus getrennt geführt. Die beiden Anschlüsse 45, 46 können an einen gemeinsamen Pol der in dieser Zeichnung nicht gezeigten Treiberstromversorgungsquelle angeschlossen sein. Die Kondensatoren 58, 59 blocken die Treiberstromversorgungsanschlüsse 45, 46 gegen den Mittelpunkt 32, der am anderen Pol der Treiberstromversorgungsquelle angeschlossen sein kann, ab.

Die Begleitleitung 35 führt vom Anschluss 45 in die Nähe der Mittelanzapfung 30 und weiter als bifilare Begleitwicklung der oberen Hälfte 23a der Primärwicklung 23 zum Power-In-Anschluss 47 des Treibers 7 der Halbbrücke 5. Analog führt die Begleitleitung 36 vom Anschluss 46 ebenfalls in die Nähe der Mittelanzapfung 30 und dann weiter als bifilare Begleitwicklung der unteren Hälfte 23b der Primärwicklung 23 zum Power-In-Anschluss 48 des Treibers 9 der zweiten Halbbrücke 6.

Zwischen der Ausgangsnetzwerkleitung 37, 38 und den beiden Begleitleitungen 35 und 36 der Treiberstromversorgung sind an verschiedenen Stellen Koppelkapazitäten installiert. So sind in der Nähe des Power-In-Anschlusses 47 des Treibers 7 der ersten Halbbrücke 5 Kondensatoren 39 zwischen der Begleitleitung 35 und dem Primäranschluss 56a, der das Ausgangssignal der ersten Halbbrücke 5 führt, geschaltet. Mindestens ein weiterer Kondensator 42 liegt zwischen dem Anschluss 48 des Power-In-Anschlusses des Treibers 9 der Halbbrücke 6 und dem Primäranschluss 56b, der das Ausgangssignal der zweiten Halbbrücke 6 führt. Die Kapazitäten 54, 55 und die Induktivität 27 sind Bestandteil des Impedanzanpassungsgliedes zwischen der Sekundärwicklung 24 und dem Ausgang 28 (Fig. 1).

Weitere Kondensatoren 40, 41 sind zwischen jeweils der Mittelanzapfung 30 und den in der Nähe verlaufenden Begleitleitungen 35, 36 vorgesehen, um diese drei Leitungen an dieser Stelle hochfrequenzmäßig ähnlich ruhig zu halten.

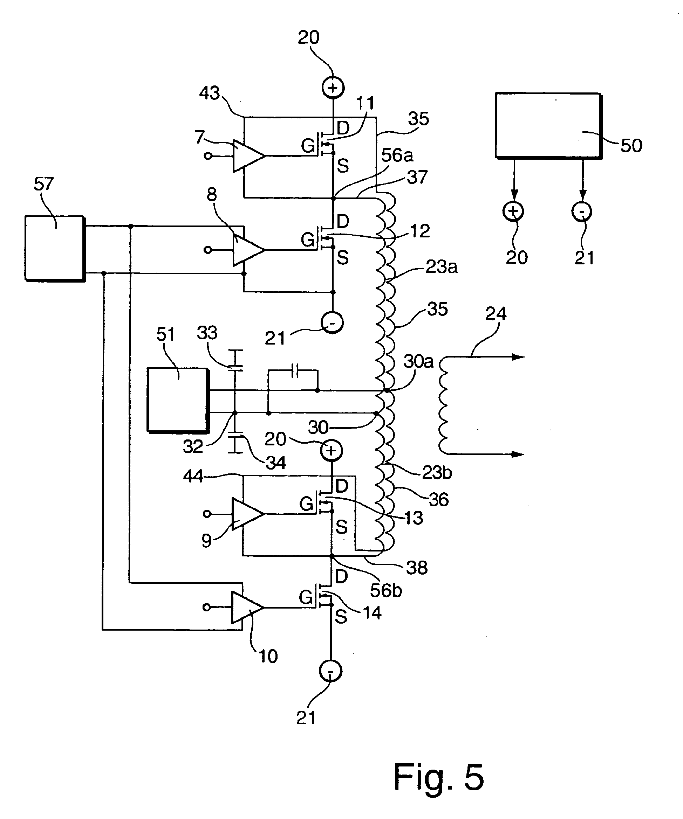

In Figur 5 ist dargestellt, wie die Top-Switch-Treiber 7 und 9 mit nur einer Treiberstromversorgungsquelle 51 betrieben werden können.

Der eine Anschluss der gemeinsamen Treiberstromversorgungsquelle 51 führt als gemeinsame Leitung der sich später aufteilenden Leitungen 35, 36 zum Zugangspunkt 30a und verzweigt sich dort. Die erste Begleitleitung 35 zur Treiberstromversorgung folgt vom Zugangspunkt 30a an der Geometrie der Wicklung 23a zu dem Power-In-Anschluss 43 des Treibers 7. Die zweite Begleitleitung 36 zur Treiberstromversorgung folgt vom Zugangspunkt 30a an der Geometrie der Wicklung 23b zu dem Power-In-Anschluss 44 des Treibers 9.

Der andere Anschluss der gemeinsamen Treiberstromversorgungsquelle 51 führt über den Mittelpunkt 32 mit den Kondensatoren 33, 34 an die Mittelanzapfung 30 der Primärwicklung 23 des Ausgangsübertragers 23, 24 und über die beiden Hälften 23a, 23b der Primärwicklung 23 und über den weiteren Weg der Ausgangsnetzwerkleitungen 37, 38 zu den Source-Anschlüssen der beiden Top-Switch-Transistoren 11 und 13 und zu den Power-Ground-Anschlüssen der Treiber 7 und 9.

Durch diese Schaltung wird die Spannungsversorgung der Gates der Top-Switch-Transistoren 11 und 13 wesentlich vereinfacht, da nur noch eine Treiberstromversorgungsquelle 51 für alle Top-Switch-Treiber 7, 9 benötigt wird.

Die Treiberstromversorgungsquelle 57 speist die hochfrequenzmäßig ruhigen Bottom-Switch-Treiber 8, 10 auf herkömmliche Art. Da in den Treiberstromversorgungsleitungen der Top-Switch-Treiber 7, 9 keine Common-Mode-Drosseln enthalten sind, entfallen auch die sonst aus Symmetriegründen notwendigen Common-Mode-Drosseln in den Treiberstromversorgungsleitungen für die Bottom-Switch-Treiber.

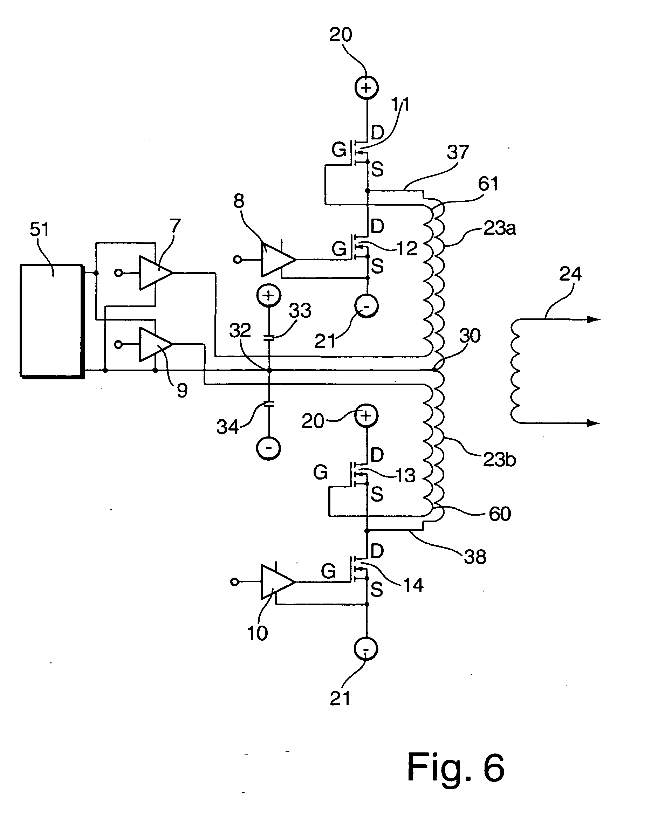

In der Schaltungsvariante der Figur 6 befinden sich die Treiber 7, 9 auf einem hochfrequenzmäßig ruhigen Potential, während sich die zugehörigen Top-Switch-Transistoren 11, 13 auf einem stark wechselnden Potential befinden. Die Begleitleitungen 60, 61 werden hier nicht für die Treiberstromversorgung, sondern direkt für die Gateansteuerung der Top-Switch-Transistoren 11, 13 verwendet.

Die Begleitleitung 61 kommt vom Ausgang des Treibers 7, folgt als Begleitwicklung den räumlichen Strukturen der oberen Hälfte 23a der Primärwicklung 23 und führt zum Gate-Anschluss des Transistors 11. In äquivalenter Weise kommt die Begleitleitung 60 vom Ausgang des Treibers 9, folgt den räumlichen Strukturen der Wicklungshälfte 23b und führt zum Gate-Anschluss des Transistors 13. Die Masseleitung der Treiber 7, 9 ist über den Mittelpunkt 32 an die Mittelanzapfung 30 der Primärwicklung 23 angeschlossen. Die Source-Anschlüsse der Top-Switch-Transistoren 11, 13 sind an die jeweiligen Enden der Primärwicklungshälften 23a, 23b angeschlossen.

Im Nachfolgenden soll die Führung einer Begleitleitung als Treiberstromversorgung 35 oder Gatesteuerleitung 61 beim Einsatz nur einer Halbbrücke näher beschrieben werden.

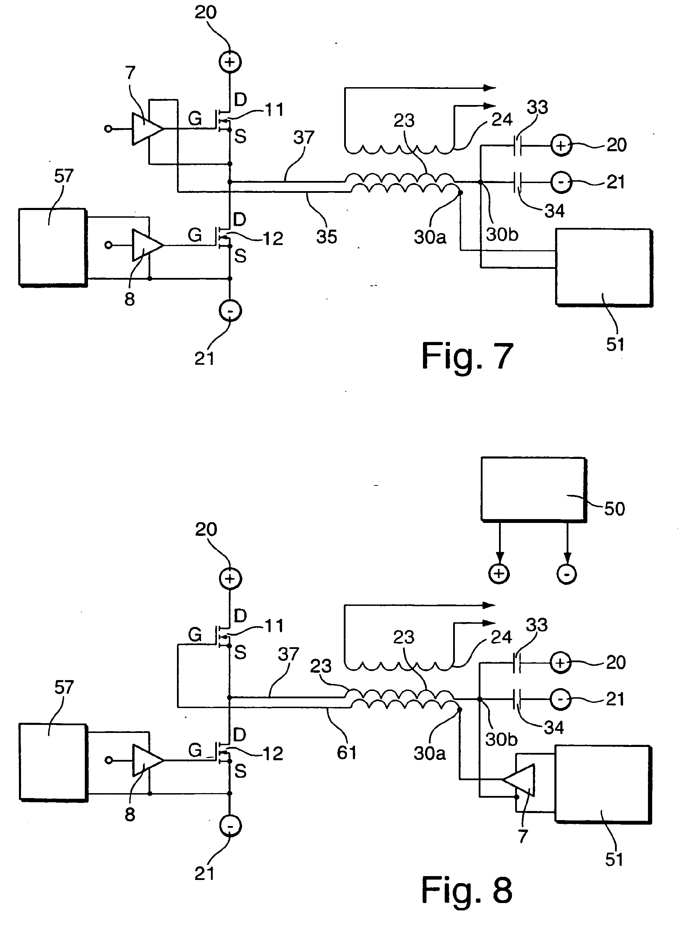

In Figur 7 ist der eine Ausgang der Treiberstromversorgungsquelle 51 für den Treiber 7 über die Begleitleitung 35 zur Treiberstromversorgung direkt mit dem Power-In-Anschluss des Treibers 7 verbunden, welcher das Gate G des Transistors 11 ansteuert. Der andere Anschluss der Treiberstromversorgungsquelle 51 führt zu einem Punkt 30b, an dem die Primärwicklung 23 über die Kondensatoren 33, 34 den Mittelpunkt der DC-Versorgung bildet und damit hochfrequenzmäßig auf Masse liegt. Der andere Anschluss der Primärwicklung 23 ist über die Ausgangsnetzwerkleitung 37 mit dem Source-Anschluss S des Transistors 11 und außerdem mit dem Power-Ground-Anschluss des Treibers 7 verbunden. Am Drain-Anschluss D des Transistors 11 liegt der positive Pol 20 der DC-Stromversorgung, deren negativer 21 Pol an der Source S des Bottom-Switch-Transistors 12 und dem Power-In-Anschluss des den Transistor 12 ansteuernden Treibers 8 liegt. Die Begleitleitung 35 und die Ausgangsnetzwerkleitung 37 sind dabei galvanisch getrennt, aber nah beieinander geführt. Dies gilt insbesondere im Bereich der Primärwicklung 23, wo die Begleitleitung 35 als Begleitwicklung ausgebildet ist.

In der alternativen Schaltungsausführung gemäß Figur 8 befindet sich der Treiber 7 auf einem hochfrequenzmäßig ruhigen Potential und ist direkt an seine Treiberstromversorgungsquelle 51 angeschlossen, der Power-Ground-Anschluss des Treibers 7 ist direkt mit dem Anschluss 30b der Primärwicklung 23 verbunden, der durch die Kondensatoren 33, 34 hochfrequenzmäßig auf Masse liegt. Die Begleitleitung 61, die hier zur Gateansteuerung dient, führt vom Steuerausgang des Treibers 7 in räumlicher Nähe zur Primärwicklung 23 des Ausgangsübertragers 23, 24 an den Gate-Anschluss G des Transistors 11.

Der andere Anschluss der Primärwicklung 23 führt über die Ausgangsnetzwerkleitung 37 zum Source-Anschluss S des Transistors 11 und liegt somit auf hohem HF-Potential.

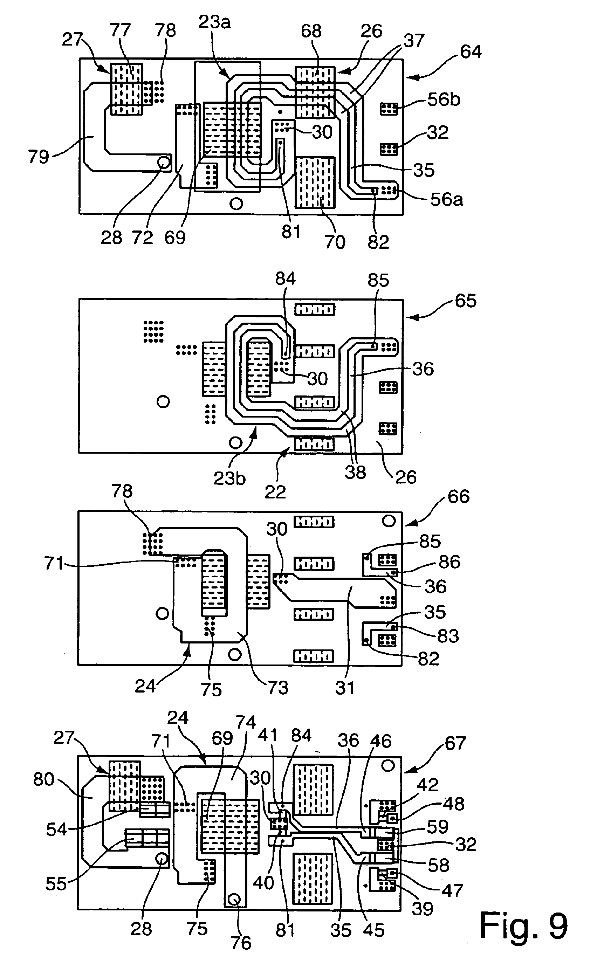

In der Figur 9 sind die unterschiedlichen Lagen einer mehrlagigen Leiterplatte dargestellt, nämlich eine untere Lage 64, eine erste innere Lage 65, eine zweite innere Lage 66 und eine obere Lage 67. Diese mehrlagige Leiterplatte bildet das Ausgangsnetzwerk und trägt planar ausgeführte Transformatoren und Induktivitäten. Die als Transistoren ausgebildeten schaltenden Elemente 11, 12, 13, 14 und ihre Treiber 7, 8, 9, 10 sind außerhalb der Leiterplatte angeordnet.

Die Ausgangsnetzwerkleitung 37, 38, 23a, 23b führt vom durchkontaktierten Anschluss 56a zunächst durch einen Ferrit 68, wodurch die erste Induktivität 26 ausgebildet wird. In der Umgebung des Ferrits 69 bildet sie die erste Hälfte 23a der Primärwicklung 23. Nach Passieren der Mittelanzapfung 30, die aus einem Durchkontaktierungsfeld gebildet ist, bildet die Ausgangsnetzwerkleitung die andere Hälfte 23b der Primärwicklung 23 auf der Lage 65. Die Ausgangsnetzwerkleitung 38 verlässt schließlich die Umgebung des Ferrits 69 und bildet bei der Durchführung durch den Ferrit 70 die zweite Induktivität 22, bevor sie mit dem durchkontaktierten Primäranschluss 56b zurück zur Lage 64 wechselt.

An die durch Durchkontaktierungen gebildete Mittelanzapfung 30 ist ebenfalls die Leitung 31 auf der Lage 66 angeschlossen, die zum Mittelpunkt der DC-Stromversorgung 32 führt, die durch einen durchkontaktierten Leiterplattenanschluss gebildet wird. In diesem Ausführungsbeispiel ist die Leitung 31 nicht als dritte Induktivität ausgebildet.

Die Sekundärwicklung 24 des Ausgangsübertragers 23, 24 beginnt auf der Lage 67 am Masseanschluss in der Bohrung 76, führt als Leiterbahn 74 ebenfalls durch den Ferrit 69, wechselt bei dem Durchkontaktierungsfeld 71 zunächst auf die Lage 64 mit der Leiterbahn 72 und die Lage 66 mit der Leiterbahn 73, beim Durchkontaktierungsfeld 75 endgültig auf die Lage 66, führt abermals durch den Ferrit 69 und endet im Durchkontaktierungsfeld 78, wo parallele Leiterbahnen 79 und 80 auf den Lagen 64 und 67 durch den Ferrit 77 für die Bildung der Induktivität 27 sorgen. Diese beiden Leiterbahnen enden in dem Ausgangsanschluss 28, der durch eine Bohrung gebildet wird. Vom Durchkontaktierungsfeld 78 sind die Kondensatoren 54 und vom Ende der Leiterbahnen bei der Bohrung 28 sind die Kondensatoren 55 jeweils nach Masse geschaltet. Die Kondensatoren 54, 55 und die Induktivität 27 bilden das Impedanzanpassungsnetzwerk.

Die Ferrite bewirken jeweils eine Verstärkung des hochfrequenten Magnetfeldes.

Bei dieser planaren Ausgestaltung werden die Begleitleitungen 35, 36 als Treiberstromversorgungsleitungen für die Top-Switch-Treiber 7, 9 in der Mitte der Ausgangsnetzwerkleitung 37, 38, 23a, 23b geführt.

Die Begleitleitung 35 für die Treiberstromversorgung des Top-Switch-Treibers 7 beginnt auf Lage 67 beim Anschluss 45, an den die hier nicht gezeigte externe Treiberstromversorgungsquelle 51 angeschlossen ist. Die Begleitleitung 35 führt zunächst auf der Lage 67 höhenparallel zur Leitung 31 zu einem Zugangspunkt 81, der durch eine Durchkontaktierung in räumlicher Nähe der Mittelanzapfung 30 gebildet wird. Dort wechselt sie auf die Lage 64 und verläuft als Begleitleitung isoliert in der Mitte der Ausgangsnetzwerkleitung 37, ist insbesondere im Bereich des Ferrits 69 eine Begleitwicklung der Primärwicklungshälfte 23a und kommt bis in die Nähe des Primäranschlusses 56a. Die Durchkontaktierung 82 führt die Begleitleitung 35 auf die Lage 66, von wo aus die Durchkontaktierung 83 den Anschluss 47 bereitstellt, an den der Power-In-Anschluss des außerhalb der Leiterplatte befindlichen Top-Switch-Treibers 7 angeschlossen ist.

Die Begleitleitung 36 für die Treiberstromversorgung des Top-Switch-Treibers 9 beginnt ebenfalls auf Lage 67 beim Anschluss 46, der auch an die externe Treiberstromversorgungsquelle 51 angeschlossen ist. Die Begleitleitung 36 führt höhenparallel zur Leitung 31 zu einem Zugangspunkt 84, der durch eine Durchkontaktierung in räumlicher Nähe der Mittelanzapfung 30 gebildet wird. Dort wechselt die Begleitleitung auf die Lage 65 und verläuft als Begleitleitung 36 isoliert in der Mitte der Ausgangsnetzwerkleitung 38, ist insbesondere im Bereich des Ferrits 69 eine Begleitwicklung der Primärwicklungshälfte 23b und kommt bis in die Nähe des Primäranschlusses 56b. Die Durchkontaktierung 85 führt die Begleitleitung 36 auf die Lage 66, von wo aus die Durchkontaktierung 86 den Anschluss 48 bereitstellt, an den der außerhalb der Leiterplatte befindliche Top-Switch-Treiber 9 angeschlossen ist.

Die beiden Stellen bei den Zugangspunkten 81, 84 sind gegenüber der Mittelanzapfung 30 mit den Kondensatoren 40, 41 abgeblockt und damit die hochfrequenzmäßig letzten ruhigen Stellen, bevor die Begleitleitungen 35, 36 ihren Weg als Begleitwicklungen in der Mitte der Ausgangsnetzwerkleitung 37, 38 fortsetzen.

Beide Anschlüsse 45, 46 können an denselben Pol derselben Treiberstromversorgungsquelle angeschlossen sein. Der zweite Pol der Treiberstromversorgungsquelle kann dann an den Mittelpunkt 32 angeschlossen sein, der über die Leitung 31 mit dem Durchkontaktierungsfeld der Mittelanzapfung 30 verbunden ist. Die Kondensatoren 58, 59 blocken die Begleitleitungen 35, 36 bei den Anschlüssen 45, 46 gegen den Mittelpunkt 32 ab.

## Patentansprüche

1. Hochfrequenzstromversorgungsanordnung, insbesondere eine Plasmaversorgungseinrichtung zur Erzeugung einer Ausgangsleistung > 500 W und einer Ausgangsfrequenz > 3 MHz mit mindestens einem an eine DC-Stromversorgung angeschlossenen Inverter, der zumindest ein schaltendes Element aufweist, dessen Bezugspotential sich im Takt der Hochfrequenz ändert, und mindestens einem Ausgangsnetzwerk
**dadurch gekennzeichnet, dass**
eine Begleitleitung (35, 36; 60, 61) ein elektrisches Bauteil (7, 9, 11, 13), das sich auf einem Bezugspotential mit starken zeitlichen Änderungen befindet, mit einer von zeitlichen Veränderungen eines Spannungspotentials weitgehend freien Zugangspunkt (30a, 45, 46) verbindet.

2. Hochfrequenzstromversorgungsanordnung nach Anspruch 1,
**dadurch gekennzeichnet, dass** die Begleitleitung (35, 36; 60, 61) - im Bereich einer Ausgangsnetzwerkleitung (37, 38, 23, 23a, 23b) angeordnet ist, an welcher im Betrieb ein Hochfrequenzstrom fließt.

3. Hochfrequenzstromversorgungsanordnung nach Anspruch 2,
**dadurch gekennzeichnet, dass** die Begleitleitung (35, 36, 60, 61) im Bereich einer Wicklung der Ausgangsnetzwerkleitung (37, 38, 23, 23a, 23b), insbesondere im Bereich einer Primärwicklung (23) eines Ausgangsübertragers (23, 24) des Ausgangsnetzwerkes (15), als Begleitwicklung ausgebildet ist.

4. Hochfrequenzstromversorgungsanordnung nach einem der vorhergehenden Ansprüche, **dadurch gekennzeichnet, dass**
a) die Begleitleitung (35, 36, 60, 61) mit der Ausgangsnetzwerkleitung (37, 38, 23, 23a, 23b) verdrillt ist, und/oder
b) die Begleitleitung (35, 36; 60, 61) parallel zu der Ausgangsnetzwerkleitung (37, 38, 23, 23a, 23b) angeordnet ist, und/oder
c) die Begleitleitung (35, 36; 60, 61) bifilar zu der Ausgangsnetzwerkleitung (37, 38, 23, 23a, 23b) angeordnet ist, und/oder
d) die Begleitleitung (35, 36; 60, 61) räumlich oder flächig von der Ausgangsnetzwerkleitung umgeben oder umschlossen ist, und/oder
e) die Ausgangsnetzwerkleitung (37, 38, 23, 23a, 23b) planar ausgeführt ist, wobei die Begleitleitung (35, 36, 60, 61) in der Mitte der Ausgangsnetzwerkleitung (37, 38) ausgeführt ist, und/oder
f) die Begleitleitung (35, 36, 60, 61) von einer rohrförmigen Ausgangsnetzwerkleitung (37, 38, 23, 23a, 23b) umschlossen ist, und/oder
g) die Hochfrequenzstromversorgungsanordnung auf einer mehrlagigen Leiterplatte (64, 65, 66, 67) angeordnet ist, wobei die Begleitleitung (35, 36, 60, 61) auf einer parallelen Lage im Bereich der Ausgangsnetzeitung (37, 38, 23, 23a, 23b) angeordnet ist.

5. Hochfrequenzstromversorgungsanordnung nach einem der vorhergehenden Ansprüche, **dadurch gekennzeichnet, dass** die Begleitleitung (35, 36, 60, 61) durch ein, ein Magnetfeld erhöhendes Bauteil (69) des Ausgangsübertragers (23, 24) geführt ist.

6. Hochfrequenzstromversorgungsanordnung nach einem der vorhergehenden Ansprüche, **dadurch gekennzeichnet, dass** die Begleitleitung (35, 36) eine Treiberstromversorgungsleitung ist, die den Treiberversorgungsstrom einer Treiberstromversorgungsquelle (51) entlang der Ausgangsnetzwerkleitung (37, 38, 23, 23a, 23b) zu einem Treiber (7, 9) des schaltenden Elementes (11, 13) des Inverters (3) führt.

7. Hochfrequenzstromversorgungsanordnung nach einem der vorhergehenden Ansprüche, **dadurch gekennzeichnet, dass** der Zugangspunkt (30a) der Begleitleitung (35, 36, 60, 61) in der Nähe des von zeitlichen Veränderungen eines elektrischen Potentials weitgehend freien Punktes (Mittelanzapfung 30, 30b) der Primärwicklung (23) des Ausgangsübertragers (23, 24) des Ausgangsnetzwerkes (15) ist.

8. Hochfrequenzstromversorgungsanordnung nach einem der vorhergehenden Ansprüche, **dadurch gekennzeichnet, dass** der Inverter (3) zwei Halbbrücken (5, 6) aufweist und der Zugangspunkt (30a, 81, 84) der Begleitleitung im Bereich der Mittelanzapfung (30) der Primärwicklung (23) des Ausgangsübertragers (23, 24) ausgebildet ist.

9. Hochfrequenzstromversorgungsanordnung nach einem der vorhergehenden Ansprüche, **dadurch gekennzeichnet, dass** die Ausgangsnetzwerkleitung (37, 38, 23, 23a, 23b) und die Begleitleitung (35, 36, 60, 61) kapazitiv miteinander verbunden sind.

10. Hochfrequenzstromversorgungsanordnung nach einem der vorhergehenden Ansprüche, **dadurch gekennzeichnet, dass** eine als Steuerleitung ausgebildete Begleitleitung (60, 61) über den Zugangspunkt (30a, 81, 84) direkt an einen Steueranschluss (G) eines schaltenden Elementes (11, 13) des Inverters (3) führt.

11. Hochfrequenzstromversorgungsanordnung nach einem der vorhergehenden Ansprüche, **dadurch gekennzeichnet, dass** eine als Messleitung ausgebildete Begleitleitung (35, 36, 60, 61) ein elektrisches Bauteil, das sich auf einem Bezugspotential mit starken zeitlichen Änderungen befindet, über den Zugangspunkt (30a, 81, 84) mit einer Messeinrichtung verbindet, die sich auf einem hochfrequenzmäßig ruhigen Potential befindet.

12. Verfahren zum Betreiben einer Hochfrequenzstromversorgungsanordnung, insbesondere einer Plasmastromversorgung, mit einer Treiberstromversorgung für einen Treiber in einem Inverter, bei welchem das Bezugspotential eines in dem Inverter enthaltenen schaltenden Elementes gegenüber Masse auf einem Hochfrequenzpotential liegt,
**dadurch gekennzeichnet, dass** der Versorgungsstrom des Treibers in einen von einem Hochfrequenzpotential freien Zugangspunkt eines Ausgangsnetzwerkes über eine Begleitleitung eingespeist wird.

13. Verfahren nach Anspruch 12 **dadurch gekennzeichnet, dass** die Begleitleitung im Bereich einer Ausgangsnetzwerkleitung geführt wird.

14. Verfahren zum Betreiben einer Hochfrequenzstromversorgungsanordnung, insbesondere einer Plasmastromversorgung, mit einem Treiber in einem Inverter, bei welchem das Bezugspotential eines in dem Inverter enthaltenen schaltenden Elementes gegenüber Masse zwischen unterschiedlichen Potentialen hin und her springt,
**dadurch gekennzeichnet, dass**
ein Treiberausgangssignal für das schaltende Element in einen von einem zeitlich veränderlichen elektrischen Potential weitgehend freien Zugangspunkt eines Ausgangsnetzwerkes über eine Begleitleitung eingespeist wird.

15. Verfahren nach Anspruch 14, **dadurch gekennzeichnet, dass** die Begleitleitung im Bereich einer Ausgangsnetzwerkleitung geführt wird.

## Claims

1. A high frequency power supply arrangement, in particular a plasma supply device for generating an output power > 500 W and an output frequency > 3 MHz, with at least one inverter which is connected to a DC power supply and which has at least one switching element whose reference potential changes synchronously with the high frequency, and with at least one output network
**characterised in that**
an accompanying line (35, 36; 60, 61) connects an electrical component (7, 9, 11, 13), which lies on a reference potential with substantial time variations, to an access point (30a, 45, 46) that is largely free from time variations of a voltage potential.

2. The high frequency power supply arrangement according to Claim 1, **characterised in that** the accompanying line (35, 36; 60, 61) is arranged in the region of an output network line (37, 38, 23, 23a, 23b) to which a high frequency current flows in operation.

3. The high frequency power supply arrangement according to Claim 2, **characterised in that** the accompanying line (35, 36, 60, 61) is designed as an associated winding in the region of a winding of the output network line (37, 38, 23, 23a, 23b), in particular in the region of a primary winding (23) of an output transformer (23, 24) of the output network (15).

4. The high frequency power supply arrangement according to one of the preceding claims, **characterised in that**
a) the accompanying line (35, 36, 60, 61) is twisted with the output network line (37, 38, 23, 23a, 23b), and/or
b) the accompanying line (35, 36; 60, 61) is arranged parallel to the output network line (37, 38, 23, 23a, 23b), and/or
c) the accompanying line (35, 36; 60, 61) is arranged in a bifilar manner relative to the output network line (37, 38, 23, 23a, 23b), and/or
d) the accompanying line (35, 36; 60, 61) is surrounded or enclosed spatially or in a planar manner by the output network line, and/or
e) the output network line (37, 38, 23; 23a, 23b) has a planar design, wherein the accompanying line (35, 36, 60, 61) is arranged in the centre of the output network line (37, 38), and/or
f) the accompanying line (35, 36, 60, 61) is enclosed by a tubular shaped output network line (37, 38, 23, 23a, 23b), and/or
g) the high frequency power supply arrangement is arranged on a multi-layer circuit board (64, 65, 66, 67), wherein the accompanying line (35, 36, 60, 61) is arranged on a parallel layer in the region of the output network line (37, 38, 23, 23a, 23b).

5. The high frequency power supply arrangement according to one of the preceding claims, **characterised in that** the accompanying line (35, 36, 60, 61) is run through a component (69) of the output transformer (23, 24) that increases the magnetic field.

6. The high frequency power supply arrangement according to one of the preceding claims, **characterised in that** the accompanying line (35, 36) is a driver power supply line which feeds the driver supply current of a driver power supply source (51) along the output network line (37, 38, 23, 23a, 23b) to a driver (7, 9) of the switching element (11, 13) of the inverter (3).

7. The high frequency power supply arrangement according to one of the preceding claims, **characterised in that** the access point (30a) of the accompanying line (35, 36, 60, 61) is in the vicinity of the point (central tapping 30, 30b) of the primary winding (23) of the output transformer (23, 24) of the output network (15) that is largely free from time variations of an electrical potential.

8. The high frequency power supply arrangement according to one of the preceding claims, **characterised in that** the inverter (3) has two half bridges (5, 6) and **in that** the access point (30a, 81, 84) of the accompanying line is formed in the region of the central tapping (30) of the primary winding (23) of the output transformer (23, 24).

9. The high frequency power supply arrangement according to one of the preceding claims, **characterised in that** the output network line (37, 38, 23, 23a, 23b) and the accompanying line (35, 36, 60, 61) are capacitively connected to each other.

10. The high frequency power supply arrangement according to one of the preceding claims, **characterised in that** an accompanying line (60, 61) designed as a control line leads via the access point (30a, 81, 84) directly to a control connection (G) of a switching element (11, 13) of the inverter (3).

11. The high frequency power supply arrangement according to one of the preceding claims, **characterised in that** an accompanying line (35, 36, 60, 61) designed as a measuring line connects an electrical component, which lies on a reference potential with substantial time variations, via the access point (30a, 81, 84) to a measuring device which is on a high frequency steady potential.

12. A method for operating a high frequency power supply arrangement, in particular a plasma power supply, with a driver power supply for a driver in an inverter, wherein the reference potential of a switching element contained in the inverter lies on a high frequency potential relative to earth,
**characterised in that**
the supply current of the driver is fed into an access point of an output network that is free from a high frequency potential via an accompanying line.

13. The method according to Claim 12, **characterised in that** the accompanying line is guided in the region of an output network line.

14. A method for operating a high frequency power arrangement, in particular a plasma power supply, with a driver in an inverter, wherein the reference potential of a switching element contained in the inverter jumps backwards and forwards relative to earth between different potentials,
**characterised in that**
a driver output signal for the switching element is fed into an access point of an output network that is largely free from a time variable electrical potential via an accompanying line.

15. The method according to Claim 14, **characterised in that** the accompanying line is guided in the region of an output network line.

## Revendications

1. Dispositif d'alimentation en courant à haute fréquence, en particulier d'un dispositif d'alimentation en plasma, servant à générer une puissance de sortie > 500 W et une fréquence de sortie > 3 MHz avec au moins un onduleur raccordé à une alimentation en courant continu qui présente au moins un élément de commutation dont le potentiel de référence varie au rythme de la haute fréquence, et au moins un réseau de sortie,
**caractérisé en ce que**
une ligne auxiliaire (35, 36 ; 60, 61) relie un composant électrique (7, 9, 11, 13), qui se trouve à un potentiel de référence à fortes variations dans le temps, à un point d'accès (30a, 45, 46) en grande partie exempt de variations dans le temps d'un potentiel de tension.

2. Dispositif d'alimentation en courant à haute fréquence selon la revendication 1, **caractérisé en ce que** la ligne auxiliaire (35, 36 ; 60, 61) est disposée au voisinage d'une ligne de réseau de sortie (37, 38, 23, 23a, 23b) sur laquelle un courant à haute fréquence circule en fonctionnement.

3. Dispositif d'alimentation en courant à haute fréquence selon la revendication 2, **caractérisé en ce que** la ligne auxiliaire (35, 36 ; 60, 61) est réalisée sous la forme d'un enroulement auxiliaire au voisinage d'un enroulement de la ligne de réseau de sortie (37, 38, 23, 23a, 23b), en particulier au voisinage d'un enroulement primaire (23) d'un transformateur de sortie (23, 24) du réseau de sortie (15).

4. Dispositif d'alimentation en courant à haute fréquence selon une des revendications précédentes, **caractérisé en ce que**
a) la ligne auxiliaire (35, 36, 60, 61) est torsadée avec la ligne de réseau de sortie (37, 38, 23, 23a, 23b), et/ou
b) la ligne auxiliaire (35, 36 ; 60, 61) est disposée en parallèle sur la ligne de réseau de sortie (37, 38, 23, 23a, 23b), et/ou
c) la ligne auxiliaire (35, 36 ; 60, 61) est disposée de manière bifilaire avec la ligne de réseau de sortie (37, 38, 23, 23a, 23b), et/ou
d) la ligne auxiliaire (35, 36 ; 60, 61) est entourée ou renfermée dans l'espace ou à plat par la ligne de réseau de sortie, et/ou
e) la ligne de réseau de sortie (37, 38, 23, 23a, 23b) est réalisée de manière planaire, la ligne auxiliaire (35, 36, 60, 61) étant réalisée au milieu de la ligne de réseau de sortie (37, 38), et/ou
f) la ligne auxiliaire (35, 36, 60, 61) est renfermée par une ligne de réseau de sortie tubulaire (37, 38, 23, 23a, 23b), et/ou
g) le dispositif d'alimentation en courant à haute fréquence est disposé sur une carte de circuit imprimé multicouche (64, 65, 66, 67), la ligne auxiliaire (35, 36, 60, 61) étant disposée sur une couche parallèle au voisinage de la ligne de réseau de sortie (37, 38, 23, 23a, 23b).

5. Dispositif d'alimentation en courant à haute fréquence selon une des revendications précédentes, **caractérisé en ce que** la ligne auxiliaire (35, 36, 60, 61) passe à travers un composant (69) du transformateur de sortie (23, 24) qui augmente un champ magnétique.

6. Dispositif d'alimentation en courant à haute fréquence selon une des revendications précédentes, **caractérisé en ce que** la ligne auxiliaire (35, 36) est une ligne d'alimentation en courant de circuit d'attaque qui amène le courant d'alimentation de circuit d'attaque d'une source d'alimentation en courant de circuit d'attaque (51) à un circuit d'attaque (7, 9) de l'élément de commutation (11, 13) de l'onduleur (3) le long de la ligne de réseau de sortie (37, 38, 23, 23a, 23b).

7. Dispositif d'alimentation en courant à haute fréquence selon une des revendications précédentes, **caractérisé en ce que** le point d'accès (30a) de la ligne auxiliaire (35, 36, 60, 61) est à proximité du point en grande partie exempt de variations dans le temps d'un potentiel électrique (point milieu 30, 30b) de l'enroulement primaire (23) du transformateur de sortie (23, 24) du réseau de sortie (15).

8. Dispositif d'alimentation en courant à haute fréquence selon une des revendications précédentes, **caractérisé en ce que** l'onduleur (3) présente deux demi-ponts (5, 6) et le point d'accès (30a, 81, 84) de la ligne auxiliaire est réalisé au voisinage du point milieu (30) de l'enroulement primaire (23) du transformateur de sortie (23, 24).

9. Dispositif d'alimentation en courant à haute fréquence selon une des revendications précédentes, **caractérisé en ce que** la ligne de réseau de sortie (37, 38, 23, 23a, 23b) et la ligne auxiliaire (35, 36, 60, 61) sont reliées entre elles capacitivement.

10. Dispositif d'alimentation en courant à haute fréquence selon une des revendications précédentes 15, **caractérisé en ce qu'**une ligne auxiliaire (60, 61) conçue comme une ligne de commande conduit directement à une borne de commande (G) d'un élément de commutation (11, 13) de l'onduleur (3) via le point d'accès (30a, 81, 84).

11. Dispositif d'alimentation en courant à haute fréquence selon une des revendications précédentes, **caractérisé en ce qu'**une ligne auxiliaire (35, 36, 60, 61) conçue comme une ligne de mesure relie via le point d'accès (30a, 81, 84) un composant électrique qui se trouve à un potentiel de référence à fortes variations dans le temps, à un dispositif de mesure qui se trouve à un potentiel stable aux hautes fréquences.

12. Procédé de fonctionnement d'un dispositif d'alimentation en courant à haute fréquence, en particulier d'une alimentation en courant plasma, avec une alimentation en courant de circuit d'attaque pour un circuit d'attaque dans un onduleur, dans lequel le potentiel de référence d'un élément de commutation contenu dans l'onduleur est à un potentiel à haute fréquence par rapport à la masse,
**caractérisé en ce que**
le courant d'alimentation du circuit d'attaque est injecté dans un point d'accès exempt d'un potentiel à haute fréquence d'un réseau de sortie via une ligne auxiliaire.

13. Procédé selon la revendication 12, **caractérisé en ce que** la ligne auxiliaire est conduite au voisinage d'une ligne de réseau de sortie.

14. Procédé de fonctionnement d'un dispositif d'alimentation en courant à haute fréquence, en particulier d'une alimentation en courant plasma, avec un circuit d'attaque dans un onduleur, dans lequel le potentiel de référence d'un élément de commutation contenu dans l'onduleur va et vient entre différents potentiels par rapport à la masse,
**caractérisé en ce que**
un signal de sortie de circuit d'attaque pour l'élément de commutation est injecté dans un point d'accès en grande partie exempt de potentiel électrique variable dans le temps d'un réseau de sortie via une ligne auxiliaire.

15. Procédé selon la revendication 14, **caractérisé en ce que** la ligne auxiliaire est conduite au voisinage d'une ligne de réseau de sortie.
